# FASCICULE DE BREVET EUROPEEN

(11) **EP 0 739 155 B1**
(45) Date de publication et mention de la délivrance du brevet: **23.09.1998**
(21) Numéro de dépôt: 96400832.0
(22) Date de dépôt: 18.04.1996
(51) Int. Cl.: H05H 1/46, H01J 37/32

(54) **Dispositif pour créer deux ou plusieurs décharges plasma dans un même tube guide d'onde**
Vorrichtung zur Erzeugung zwei oder mehrere Entladungen in einem Gleichwellenleiternrohr
Device for generating two or more plasma discharges within a single waveguide tube

(30) Priorité: 21.04.1995 FR 9504802
(43) Date de publication de la demande: 23.10.1996
(73) Titulaire: USTL - UNIVERSITE DES SCIENCES ET TECHNIQUES DE LILLE, 59650 Villeneuve d'Ascq (FR)
(72) Inventeur: Goudmand, Pierre, 59800 Lille (FR); Dessaux, Odile, 59800 Lille (FR); Dupret, Christian, 59110 La Madeleine (FR)
(74) Mandataire: Keib, Gérard

(56) Documents cités:
- EP-A- 0 197 843
- EP-A- 0 415 122
- US-A- 5 049 843
- US-A- 5 389 153
- PATENT ABSTRACTS OF JAPAN vol. 009, no. 045 (C-268) 26 Février 1985 & JP-A-59 189 130 (TOYOTA JIDOSHA KK) 26 Octobre 1984
- PATENT ABSTRACTS OF JAPAN vol. 013, no. 470 (E-835) 24 Octobre 1989 & JP-A-01 184 921 (CANON INC) 24 Juillet 1989

## Description

La présente invention concerne un dispositif pour créer un plasma gazeux comprenant un générateur d'onde électromagnétique relié à l'une des extrémités d'un tube guide d'onde, deux tubes d'arrivée de gaz débouchant dans ledit tube guide d'onde.

Dans les réalisations connues, voir par exemple US-A-5,389,153, dans le tube guide d'onde débouche un tube en matériau diélectrique relié d'une part à une source de gaz, tel que de l'azote, et d'autre part à une enceinte de traitement.

Le flux de gaz s'écoulant dans le tube ci-dessus, traverse par conséquent le guide dans lequel l'onde électromagnétique est véhiculée et subit une décharge qui génère un plasma.

Lorsqu'on désire, à partir d'un générateur d'onde unique, créer plusieurs zones de décharge, chacune d'elles étant reliée à une enceinte de traitement par plasma, on utilise un diviseur d'énergie relié par câbles coaxiaux à un nombre désiré de coupleurs c'est-à-dire par exemple de tubes guides d'onde traversés chacun par un tube à gaz.

Cette disposition convient généralement pour de petites puissances de décharge.

Une autre disposition consiste à utiliser un montage fractionnant l'énergie par dichotomie. Dans ce montage, le tube guide d'onde principal relié au générateur unique est relié à des ramifications successives aux extrémités desquelles on réalise les couplages avec les tubes à gaz.

Dans le cas de l'utilisation d'un diviseur d'énergie, la tenue en puissance et les pertes d'énergie font que cette version ne peut convenir qu'à de faibles puissances.

L'utilisation d'un montage par dichotomie présente les inconvénients de la complexité de la construction, et de la difficulté d'obtenir un équilibre entre les différents coupleurs.

Le but de la présente invention est de réaliser un dispositif permettant de créer plusieurs zones de décharge plasma micro-onde à partir d'un générateur d'onde unique, ne présentant pas les inconvénients des réalisations connues ci-dessus.

L'invention vise ainsi un dispositif pour créer un plasma gazeux comprenant un générateur d'onde électromagnétique relié à l'une des extrémités d'un tube guide d'onde, un tube à décharge d'arrivée de gaz débouchant dans ledit tube guide d'onde.

Suivant l'invention, ce dispositif est caractérisé en ce qu'au moins un deuxième tube à décharge d'arrivée de gaz, débouche dans ledit tube guide d'onde à une certaine distance du premier tube d'arrivée de gaz, en ce que dans l'extrémité du tube guide d'onde opposée au générateur est monté de façon coulissante un piston permettant de régler la distance entre ledit piston et l'axe d'alignement dudit premier ou autres tubes de gaz et en ce que des moyens sont prévus pour régler la distance comprise entre les axes dudit premier et autres tubes d'arrivée de gaz.

On crée ainsi à partir d'un générateur d'onde et d'un tube guide d'onde unique deux ou plusieurs zones de décharge plasma micro-onde situées dans les zones où ledit premier et autres tubes d'arrivée de gaz débouchent dans le tube guide d'onde. Chaque tube à décharge peut ainsi être relié à une enceinte de traitement par plasma. Un tel dispositif est simple à réaliser, n'engendre pas de pertes d'énergie et son fonctionnement peut être facilement équilibré, grâce au réglage de la position du piston et des tubes d'arrivée du gaz.

En effet, le piston constitue vis-à-vis de l'onde véhiculée dans le tube guide venant du générateur, un court-circuit. Le court-circuit permet de créer une onde stationnaire. Le réglage de la position du piston permet de déplacer les ventres d'intensité de l'onde. Le réglage de la position des tubes d'arrivée de gaz permet de créer des zones de décharge plasma au niveau des ventres de l'onde stationnaire et ainsi d'obtenir un fonctionnement stable équilibré et avec un rendement énergétique optimal.

Selon une version préférée de l'invention, ledit premier tube d'arrivée de gaz est fixe par rapport au tube guide d'onde, tandis que l'autre tube d'arrivée de gaz est relié au tube guide d'onde par des moyens permettant de modifier la position de son axe par rapport à celui dudit premier tube.

De préférence également, la distance comprise entre le piston et l'axe dudit premier tube est égale aux trois quarts de la longueur de l'onde stationnaire dans le guide. Celle comprise entre l'axe du premier tube et celui dudit second tube est égale à une longueur d'onde de l'onde stationnaire.

D'autres particularités et avantages de l'invention apparaîtront encore dans la description ci-après.

Aux dessins annexés donnés à titre d'exemples non limitatifs:
- la figure 1 est un schéma d'ensemble du dispositif selon l'invention;
- la figure 2 est une vue en coupe longitudinale du dispositif;
- la figure 3 est une vue en plan partielle de dessus du dispositif suivant la flèche F de la figure 2;
- la figure 4 est un schéma montrant l'onde stationnaire obtenue dans le tube guide d'onde du dispositif.

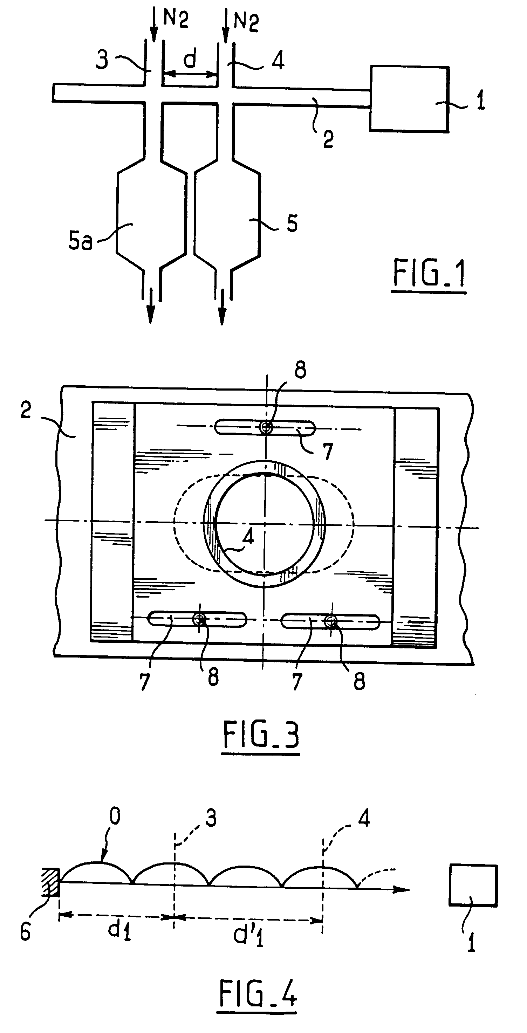

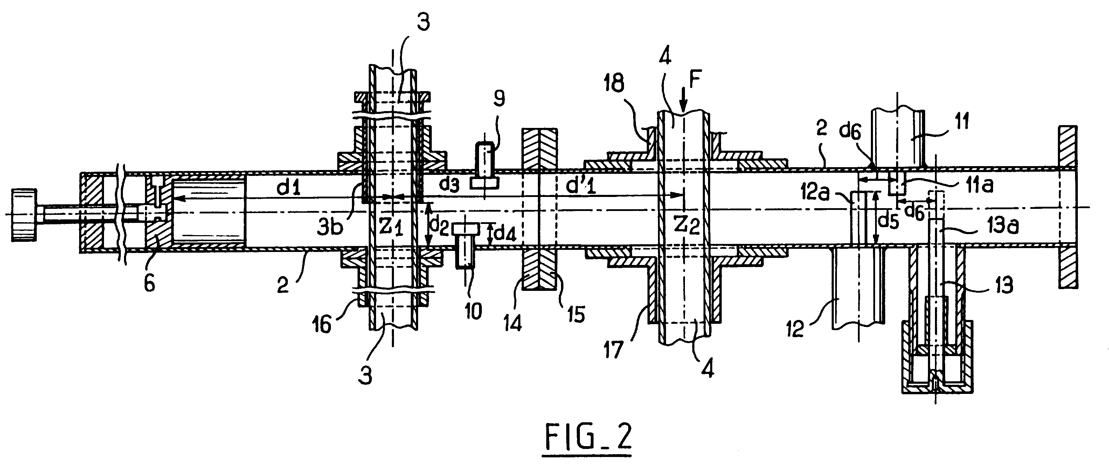

Comme montré sur les figures 1 et 2, le dispositif pour créer un plasma gazeux comprend un générateur 1 d'onde électromagnétique relié à l'une des extrémités d'un tube guide d'onde 2, un tube 3, d'arrivée de gaz tel que l'azote, débouchant dans le tube guide d'onde 2.

Conformément à l'invention, au moins un autre tube 4, d'arrivée de gaz, tel que de l'azote débouche dans le tube guide d'onde 2 à une certaine distance d du premier tube 3 d'arrivée de gaz. Les tubes 3, 4 sont reliés chacun à une enceinte de traitement 5, 5a.

On voit sur la figure 2 que dans l'extrémité du tube guide d'onde 2 opposée au générateur 1 est monté de façon coulissante un piston 6 permettant de régler la distance d₁ entre ledit piston 6 et l'axe d'alignement 3 du tube d'arrivée de gaz. Par ailleurs, des moyens sont prévus pour régler la distance comprise entre l'axe du premier tube 3, et autre tube 4, d'arrivée de gaz.

Dans l'exemple représenté, le premier tube 3, d'arrivée de gaz est fixe par rapport au tube guide d'onde 2, tandis que l'autre tube 4, d'arrivée de gaz est relié au tube guide d'onde 2 (voir figure 3) par des moyens de fixation comprenant des vis de fixation 8 engagées dans des fentes 7, permettant de modifier la position de son axe par rapport à celui du premier tube 3.

La position du piston 6 est ajustée de façon à créer dans le tube guide d'onde 2 une onde stationnaire O, comme montré sur la figure 4.

Les axes du premier 3, et autre 4, tube d'arrivée de gaz sont situés sur des ventres de l'onde stationnaire O.

La distance d₁ comprise entre le piston 6 et l'axe du premier tube 3 est égale aux trois quarts de la longueur d'onde de l'onde stationnaire O. La distance d_{1'} comprise entre le premier tube 3 et l'axe du tube suivant 4 est égale à une longueur d'onde de l'onde stationnaire O.

Comme également montré par la figure 2, le piston 6 est en métal creux, le fond de ce creux étant dirigé vers le générateur d'onde 1. La profondeur du creux du piston 6 est de préférence égale au quart de la longueur d'onde de l'onde stationnaire. Ainsi, l'extrémité avant du piston 6 se trouve au niveau du premier vente de l'onde stationnaire, ce qui a pour effet de limiter l'échauffement.

D'autre part, le premier tube d'arrivée de gaz 3, débouche dans le tube guide d'onde 2, suivant une distance réglable d₂.

Par ailleurs, près du premier tube 3, d'arrivée de gaz, le tube guide d'onde 2 porte des vis 9, 10 dont la tête fait saillie à l'intérieur du tube guide d'onde suivant une distance réglable d₃, d₄.

En outre, près de l'autre tube 4, d'arrivée de gaz, le tube guide d'onde 2 porte des pistons plongeurs 11, 12, 13 dont l'extrémité 11a, 12a, 13a plonge dans le tube guide d'onde 2 suivant une distance réglable d₅.

De plus, la distance d₆ comprise entre les axes de coulissement des pistons 11, 12, 13 est égale au huitième de la longueur d'onde de l'onde stationnaire créée dans le tube guide d'onde 2.

Le générateur d'onde 1 peut par exemple générer une onde de fréquence égale à 2,45 GHz.

Le réglage de la position du piston 6 et celui de la position de l'axe du tube 4, permet de placer l'axe des tubes au niveau des ventres de l'onde stationnaire O créée dans le tube guide d'onde 2.

On obtient ainsi deux zones de décharge Z₁, Z₂, dans un tube guide d'onde unique et à partir d'un seul générateur 1.

Bien entendu, on pourrait faire déboucher dans le tube guide d'onde d'autres tubes d'arrivée de gaz pourvu que les axes de ceux-ci soient placés sur des ventres de l'onde stationnaire.

La partie coulissante 3b du tube 3 permet de créer un intervalle d₂ à l'intérieur du tube guide d'onde 2 permettant d'ajuster la valeur du champ électromagnétique de l'onde.

Par ailleurs, les vis 9 et 10 décalées axialement l'une de l'autre permettent l'adaptation de la composante capacitive au niveau du premier tube 3.

Les trois pistons plongeurs 11, 12, 13 dont la course est réglable, permettent d'adapter l'impédance. Leur technologie en piège à λ/2 permet d'éviter la formation d'arcs et d'échauffements.

Le tube guide d'onde 2 peut être en laiton ou tout autre métal bon conducteur. Par ailleurs, le piston 6 peut être en tout métal bon conducteur tel que le laiton et l'aluminium. Dans l'exemple de la figure 2, le tube guide d'onde 2 est deux parties reliées par des brides 14, 15. Bien entendu ce tube pourrait être d'une seule pièce.

Des pièges à onde évanescente 16, 17, 18 permettent de diminuer notablement les fuites microondes.

## Revendications

1. Dispositif pour créer un plasma gazeux comprenant un générateur d'onde électromagnétique (1) relié à l'une des extrémités d'un tube guide d'onde (2), un tube (3) d'arrivée de gaz et de départ de gaz débouchant dans ledit tube guide d'onde (2), caractérisé en ce qu'au moins un autre tube (4) d'arrivée et de départ de gaz, débouche dans ledit tube guide d'onde (2) à une certaine distance du premier tube (3), d'arrivée et de départ de gaz, en ce que dans l'extrémité du tube guide d'onde (2) opposée au générateur est monté de façon coulissante un piston (6) permettant de régler la distance entre ledit piston (6) et les axes (3) d'alignement dudit premier ou autre tube (4) d'arrivée et de départ de gaz et en ce que des moyens sont prévus pour régler les distances (d₁, d_{1'}) comprises entre les axes dudit premier (3) et autre tube (4) d'arrivée et de départ de gaz.

2. Dispositif conforme à la revendication 1, caractérisé en ce que ledit premier tube (3), d'arrivée et de départ de gaz est fixe par rapport au tube guide d'onde (2), tandis que ledit autre tube (4) d'arrivée et de départ de gaz est relié au tube guide d'onde (2) par des moyens (7, 8) permettant de modifier la position de son axe par rapport à celui dudit premier tube (3).

3. Dispositif conforme à la revendication 1, caractérisé en ce que la position du piston (6) est ajustée de façon à créer dans le tube guide d'onde (2) une onde stationnaire.

4. Dispositif conforme à la revendication 3, caractérisé en ce que les axes desdits premier (3) et autre (4) tubes d'arrivée et de départ de gaz sont situés sur des ventres de l'onde stationnaire.

5. Dispositif conforme à la revendication 4, caractérisé en ce que la distance (d₁) comprise entre le piston (6) et l'axe dudit premier tube (3) est égale aux trois quarts de la longueur d'onde de l'onde stationnaire et celle (d₁') comprise entre l'axe (3) et celui dudit autre tube (4) est égale à une longueur d'onde de l'onde stationnaire.

6. Dispositif conforme à l'une des revendications 1 à 5, caractérisé en ce que le piston (6) est en métal creux, le fond dudit creux étant dirigé vers le générateur d'onde (1).

7. Dispositif conforme à l'une des revendications 1 à 6, caractérisé en ce que le premier tube (3) d'arrivée de gaz débouche dans le tube guide d'onde (2) par une extrémité (3b) qui fait saillie dans ledit tube guide d'onde (2), suivant une distance réglable (d₂).

8. Dispositif conforme à l'une des revendications 1 à 7, caractérisé en ce que près dudit premier tube (3), d'arrivée et de départ de gaz, le tube guide d'onde (2) porte des vis (9, 10) dont la tête fait saillie à l'intérieur du tube guide d'onde, suivant une distance réglable (d₃, d₄).

9. Dispositif conforme à l'une des revendications 1 à 8, caractérisé en ce que près dudit autre tube (4) d'arrivée et de départ de gaz, le tube guide d'onde (2) porte des pistons plongeurs (11, 12, 13) dont l'extrémité (11a, 12a, 13a) plonge dans ledit tube guide d'onde (2) suivant une distance réglable.

10. Dispositif conforme à la revendication 9, caractérisé en ce que la distance (d₆) comprise entre les axes de coulissement des pistons (11, 12, 13) est égale au huitième de la longueur d'onde de l'onde stationnaire créée dans le tube guide d'onde (2).

11. Dispositif conforme à l'une des revendications 1 à 10, caractérisé en ce que la présence de pièges (16, 17, 18) évite les fuites micro-ondes.

## Patentansprüche

1. Vorrichtung zum Erzeugen eines gashaltigen Plasmas umfassend einen elektromagnetischen Wellen-Generator (1), der mit einem der Enden eines Hohlleiterrohres (2) verbunden ist, wobei ein Rohr für Gaszuleitung und Gasableitung in das Hohlleiterrohr (2) mündet, dadurch gekennzeichnet, daß wenigstens ein weiteres Rohr (4) für Gaszuleitung sowie Gasableitung in das Hohlleiterrohr (2) in einem gewissen Abstand zum ersten Rohr (3) für Gaszuleitung und Gasableitung mündet, daß an dem dem Generator gegenüberliegenden Ende des Hohlleiterrohrs (2) ein Kolben (6) verschiebbar angeordnet ist, der es ermöglicht, den Abstand zwischen dem Kolben (6) und den Fluchtachsen des ersten (3) und des weiteren Rohres (4) für Gaszuleitung und Gasableitung zu regulieren, und daß Einrichtungen vorgesehen sind, um die Abstände (d₁, d_{1'}) zu regulieren, die zwischen den Achsen des ersten (3) und des weiteren Rohres (4) für Gaszuleitung und Gasableitung liegen.

2. Vorrichtung nach Anspruch 1, dadurch gekennzeichnet, daß das erste Rohr für Gaszuleitung und Gasableitung im Verhältnis zum Hohlleiterrohr (2) fest ist, während das weitere Rohr (4) für Gaszuleitung und Gasableitung mit dem Hohlleiterrohr (2) durch Einrichtungen (7, 8) verbunden ist, die die Position seiner Achse gegenüber der des ersten Rohres (3) modifizieren können.

3. Vorrichtung nach Anspruch 1, dadurch gekcnnzeichnet, daß die Position des Kolbens (6) derart eingestellt ist, um in dem Hohlleiterrohr (2) eine stationäre Welle zu erzeugen.

4. Vorrichtung nach Anspruch 3, dadurch gekennzeichnet, daß die Achsen des ersten (3) und des weiteren Rohres (4) für Gaszuleitung und Gasableitung über den Wellenbäuchen der stationären Welle angeordnet sind.

5. Vorrichtung nach Anspruch 4, dadurch gekennzeichnet, daß der zwischen dem Kolben (6) und der Achse des ersten Rohres (3) liegende Abstand (d₁) gleich Dreiviertel der Wellenlänge der stationären Welle ist und derjenige (d'₁), der zwischen der Achse des ersten Rohres (3) und der des weiteren Rohres (4) liegt, gleich einer Wellenlänge der stationären Welle ist.

6. Vorrichtung nach einem der Ansprüche 1 bis 5, dadurch gekennzeichnet, daß der Kolben (6) aus hohlem Metall gebildet ist, wobei der Boden des Hohlraums in Richtung des Wellengenerators (1) ausgerichtet ist.

7. Vorrichtung nach einem der Ansprüche 1 bis 6, dadurch gekennzeichnet, daß das erste Rohr (3) für die Gaszuleitung in das Hohlleiterrohr (2) durch ein Ende (3b) mündct, das in das Hohlleiterrohr (2) gefolgt von einem regulierbaren Abstand (d₂) hineinragt.

8. Vorrichtung nach einem der Ansprüche 1 bis 7, dadurch gekennzeichnet, daß in der Nähe des ersten Rohres (3) für Gaszuleitung und Ableitung das Hohlleiterrohr (2) Schrauben (9, 10) umfaßt, von denen der Kopf in das Innere des Hohlleiterrohrs (2) gefolgt von einem regulierbaren Abstand (d₃, d₄) hineinragt.

9. Vorrichtung nach einem der Ansprüche 3 bis 8, dadurch gekennzeichnet, daß in der Nähe des anderen Rohres (4) für Gaszuleitung und Gasableitung das Hohlleiterrohr (2) Tauchkolben (11, 12, 13) umfaßt, von denen das Ende (11a, 12a, 13a) in das Hohlleiterrohr (2) gefolgt von einem regulierbaren Abstand versenkt ist.

10. Vorrichtung nach Anspruch 9, dadurch gekennzeichnet, daß der Abstand (d₆) zwischen den Gleitachsen der Kolben (11, 12, 13) gleich dem achten Teil der Wellenlänge der in dem Hohlleiterrohr (2) hervorgerufenen stationären Welle ist.

11. Vorrichtung nach einem der Ansprüche 1 bis 10, dadurch gekennzeichnet, daß die Anwesenheit von Fallen (16, 17, 18) das Lecken von Mikrowellen vermeidet.

## Claims

1. Device for creating a gas plasma, comprising an electromagnetic wave generator (1) connected to one of the ends of a waveguide tube (2), a gas inlet and outlet tube (3) emerging in the said waveguide tube (2), characterized in that at least one other gas inlet and outlet tube (4) emerges in the said waveguide tube (2) at a certain distance from the first gas inlet and outlet tube (3), in that a piston (6) is mounted so as to slide in that end of the waveguide tube (2) which is opposite the generator, allowing the distance between the said piston (6) and the alignment axes of the said first gas inlet and outlet tube (3) or the other gas inlet and outlet tube (4) to be adjusted and in that means are provided for adjusting the distances (d₁, d_{1'}) between the axes of the said first gas inlet and outlet tube (3) and other gas inlet and outlet tube (4).

2. Device according to Claim 1, characterized in that the said first gas inlet and outlet tube (3) is stationary with respect to the waveguide tube (2), while the said other gas inlet and outlet tube (4) is connected to the waveguide tube (2) by means (7, 8) allowing the position of its axis to be modified with respect to that of the said first tube (3).

3. Device according to Claim 1, characterized in that the position of the piston (6) is adjusted so as to create a standing wave in the waveguide tube (2).

4. Device according to Claim 3, characterized in that the axes of the said first gas inlet and outlet tube (3) and of the said other gas inlet and outlet tube (4) are located at antinodes of the standing wave.

5. Device according to Claim 4, characterized in that the distance (d₁) between the piston (6) and the axis of the said first tube (3) is equal to three-quarters of the wavelength of the standing wave and the distance (d_{1'}) between the axis [lacuna] (3) and that of the said other tube (4) is equal to a wavelength of the standing wave.

6. Device according to one of Claims 1 to 5, characterized in that the piston (6) is made of hollow metal, the bottom of the said hollow being directed towards the wave generator (1).

7. Device according to one of Claims 1 to 6, characterized in that the first gas inlet tube (3) emerges in the waveguide tube (2) via an end (3b) which projects into the said waveguide tube (2) by an adjustable distance (d₂).

8. Device according to one of Claims 1 to 7, characterized in that, near the said first gas inlet and outlet tube (3), the waveguide tube (2) has screws (9, 10), the head of which projects into the waveguide tube by an adjustable distance (d₃, d₄).

9. Device according to any one of Claims 1 to 8, characterized in that, near the said other gas inlet and outlet tube (4), the waveguide tube (2) has plunger pistons (11, 12, 13), the end (11a, 12a, 13a) of which plunges into the said waveguide tube (2) by an adjustable distance.

10. Device according to Claim 9, characterized in that the distance (d₆) between the sliding axes of the pistons (11, 12, 13) is equal to one eighth of the wavelength of the standing wave created in the waveguide tube (2).

11. Device according to one of Claims 1 to 10, characterized in that the presence of traps (16, 17, 18) prevents microwave leaks.
